# EUROPEAN PATENT APPLICATION

(11) **EP 3 502 817 A1**
(43) Date of publication of application: **26.06.2019**
(21) Application number: 17208454.3
(22) Date of filing: 19.12.2017
(51) Int. Cl.: G05B 19/418, G06F 11/36, G05B 19/042, G05B 15/02, G05B 23/02, G05B 17/02

(54) **METHOD FOR FACILITATING CONTROL SYSTEM TESTING AND SIMULATION**

(71) Applicant: ABB Schweiz AG, 5400 Baden (CH)
(72) Inventor: CASTLE, Kristin, 2020 Skedsmokorset (NO)
(74) Representative: Helin, William

(57) **Abstract**

The present disclosure relates to a computer-implemented method for facilitating control system testing, and interfacing with an external dynamic process model by means of a test and simulation tool, the control system comprising a plurality of control module aspect types, each control module aspect type being one of a control module type and a field device signal type, wherein the method comprises: c) receiving, via an I/O port of the test and simulation tool, control module aspect type data from a control module aspect type of the control system, d) converting the control module aspect type data to simplified control module aspect type data based on the control module aspect type, e) providing the simplified control module aspect type data to a simplified general control module aspect type, the simplified general control module aspect type being a simplified representation of the control module aspect type, and f) performing a feedback simulation using the simplified general control module aspect type and the simplified control module aspect type data, or g) sending the simplified control module aspect type data from the test and simulation tool to the external dynamic process model.

## Description

### TECHNICAL FIELD

The present disclosure generally relates to process control, in particular to testing and simulation aspects of a control system.

### BACKGROUND

Traditionally, control system software/logic has been tested in a quite standardized way, using for example an operator's HMI and a physical test rack, with lamps, switches and potentiometers that were hardwired to hardware controllers.

Today, testing of the control system software has moved towards software based platforms, where the control system is off-line, without any controller hardware. Testers can stimulate and verify control through software applications, and/or by using dynamic process models which can stimulate feedback.

When testing and simulating, feedback loops are needed to provide automatic response back to the control system. Feedback simulation may be added in control logic code. Hereto, feedback simulation tools may exist for a specific control system. Third party modelling tools such as Dymola® and Matlab® are other options for simulation, as is high-fidelity dynamic process models and software from model vendors. For high-fidelity models, different model vendors and software are typically specialized in different processes.

Control systems typically provide an interface (OPC DA, UA or similar) for models to stimulate 10, allowing users to select model tools and vendors according to the needed dynamic simulation.

One problem with testing control software/logic through software applications is that the software solutions can make the user interface much more complex than the traditional physical test rack. Solutions are not standardised and the tester interface can vary widely between control systems and projects.

Some existing test and simulation solutions and their drawbacks are as follows.
▪ The dynamic feedback is incorporated in the control logic. A disadvantage is the mixing of simulation code with control code. This has a safety impact with the risk that simulation is active in the controller.
▪ The use of external dynamic process models. The dynamic process models are typically designed for simulation, not for verifying control systems. Too little control system information is available to be used as a single user interface.
▪ The use of control system engineering/online software to verify and/or stimulate IO response by user. This requires knowledge of the control system tools, which can vary between each control system family. And adds complexity for the tester.
▪ The use of different tools and interfaces to validate results because one tool cannot provide all the information. This requires the user to learn to use a plurality of tools.

When software models stimulate feedback to the control system, the IO signals between the control system and the control objects are cross-coupled, where an OPC DA/UA protocol is typically used.

Many control systems have interface support that allows a dynamic process model to stimulate 10, enabling a user to choose dynamic process model tools and vendors according to the needed dynamic simulation.

When software models read commands and stimulate feedback to the control system, they need to handle IO and protocol interfacing on the control system side. The device typical can however differ quite a lot on the control system side. In addition, existing control systems use more and more intelligent devices that send data through bus protocols where feedback and commands can be packed in many different ways, adding more complexity and variety of the control object types.

On the dynamic process model side, typically all types of for example Open-Close Valves have the same simple signal interface with two feedback and two output signals for open and close. The protocols on the control side add a lot of complexity on the dynamic process model side to convert to control specific types. The complexity of cross-coupling and converting signals is caused by the IO or protocol interface of different device types, but is still handled in the model software.

A model engineer or developer needs the specification of all different control object type and protocols, and implement them in the dynamic process model. Cross-coupling and converting signals between devices in the model and the control system side can add a lot of engineering and development hours on the model side. Minor changes or extensions, such as with utility systems, will require access to dynamic process model configuration and knowledge of model software. Typically when handled by a model engineer, this it adds high costs to even low-fidelity simulation areas.

### SUMMARY

In view of the above, an object of the present disclosure is to provide a method of facilitating control system testing and simulation which solves, or at least mitigates, the problems of the prior art.

There is hence according to a first aspect of the present disclosure provided a computer-implemented method for facilitating testing of a control system, and interfacing of the control system with an external dynamic process model, by means of a test and simulation tool, the control system comprising a plurality of control module aspect types, each control module aspect type being one of a control module type and a field device signal type, wherein the method comprises: c) receiving, via an I/O port of the test and simulation tool, control module aspect type data from a control module aspect type of the control system, d) converting the control module aspect type data to simplified control module aspect type data based on the control module aspect type, e) providing the simplified control module aspect type data to a simplified general control module aspect type, the simplified general control module aspect type being a simplified representation of the control module aspect type, and f) performing a feedback simulation using the simplified general control module aspect type and the simplified control module aspect type data, or g) sending the simplified control module aspect type data from the test and simulation tool to the external dynamic process model.

The method provides a standardised test and simulation interface for control systems. In particular, the conversion to simplified general control module aspect types allows for connection to an external dynamic process model without having to adapt the external dynamic process model to the same degree to a specific control system as in previous solutions. Instead, the test and simulation tool may be automatically adapted or configured in accordance with a particular control system. The conversion which was previously implemented in the external dynamic process model is provided by means of the test and simulation tool which provides an interface between the control system and the external dynamic process model.

The feedback simulation may provide low-fidelity simulation within the test and simulation tool, which in certain situations may be desirable. This may reduce the time in setting up a simulation, and reduce the cost and simulation scope in external high-fidelity dynamic process model software. The external dynamical model which may interface with the test and simulation tool may thus provide medium or high-fidelity simulations. It is thereby possible to start with low-cost and low-fidelity simulations, with the option to at a later time switch over and integrate with medium/high-fidelity external dynamic process models.

By connecting external dynamic process models by means of the test and simulation tool, a large amount of engineering and test effort will be saved, as the protocol/IO-specific interface towards the control system is handled by the test and simulation tool. The external dynamic process model will only need to interface a small set of simplified general control module aspect types. Furthermore, the time necessary for integrating an enhanced external dynamic process model will be greatly reduced.

Additionally, the safety is increased, as simulation is done outside the control system, without impact on the control system configuration.

One embodiment comprises, prior to step c), a) obtaining all control module aspect types of the control system and all of their instances to set up interfacing control module aspect types corresponding to that of the control system.

Thus, when the interface tool is initially set up or configured, the interface tool is populated automatically with the control module aspect types. A control module aspect type configuration reflecting or mirroring that of the control system is thereby obtained in the test and simulation tool.

The time for setting up the test interface for the control system will thereby be greatly reduced, as the control system scope, or control system configuration, is automatically populated in the test and simulation tool.

One embodiment comprises b) mapping each interfacing control module aspect type to a respective simplified general control module aspect type.

According to one embodiment the mapping involves finding a match between the interfacing control module aspect types and the simplified general control module aspect types of a data set comprising a plurality of simplified general control module aspect types.

The data set, or library, may be obtained initially by manual set-up made by a user. Once the data set or library has been created, the mapping may be made automatically.

According to one embodiment step c) involves receiving the control module aspect type data by a corresponding interfacing control module aspect type.

According to one embodiment step f) involves performing a feedback simulation using the simplified control module type data to obtain feedback simulation data.

According to one embodiment in case the control module aspect type data is control module aspect type data the feedback simulation is a device feedback simulation and in case the control module aspect type data is field device signal type data the feedback simulation is a signal feedback simulation.

One embodiment comprises h) sending feedback simulation data to the control module aspect type.

According to one embodiment step h) involves converting the feedback simulation data to obtain converted feedback simulation data adapted to a protocol used by the I/O port, and sending the converted simulation data to the control module aspect type via the I/O port.

According to one embodiment the simplified general control module aspect type has fewer state parameters than the control module aspect type.

According to one embodiment step h) comprises sending the simplified control module aspect type data to the external dynamic process model via an Object linking and embedding for Process Control, OPC, server.

There is according to a second aspect of the present disclosure provided a computer program comprising computer code which when executed by processing circuitry of a test and simulation device causes the test and simulation device to perform the method according to the first aspect.

There is according to a third aspect of the present disclosure provided a computer program product comprising a storage medium provided with a computer program according to the second aspect.

Generally, all terms used in the claims are to be interpreted according to their ordinary meaning in the technical field, unless explicitly defined otherwise herein. All references to "a/an/the element, apparatus, component, means, etc. are to be interpreted openly as referring to at least one instance of the element, apparatus, component, means, etc., unless explicitly stated otherwise.

### BRIEF DESCRIPTION OF THE DRAWINGS

The specific embodiments of the inventive concept will now be described, by way of example, with reference to the accompanying drawings, in which:
Fig. 1 schematically shows a block diagram of a test and simulation device;
Fig. 2 schematically depicts a block diagram of control system software, a test and simulation tool, and an external dynamic process model interfacing with the test and simulation tool;
Fig. 3 schematically depicts a simplification of the system shown in Fig. 2; and
Fig. 4 shows a method for facilitating control system testing, and interfacing with an external dynamic process model by means of the test and simulation tool.

### DETAILED DESCRIPTION

The inventive concept will now be described more fully hereinafter with reference to the accompanying drawings, in which exemplifying embodiments are shown. The inventive concept may, however, be embodied in many different forms and should not be construed as limited to the embodiments set forth herein; rather, these embodiments are provided by way of example so that this disclosure will be thorough and complete, and will fully convey the scope of the inventive concept to those skilled in the art. Like numbers refer to like elements throughout the description.

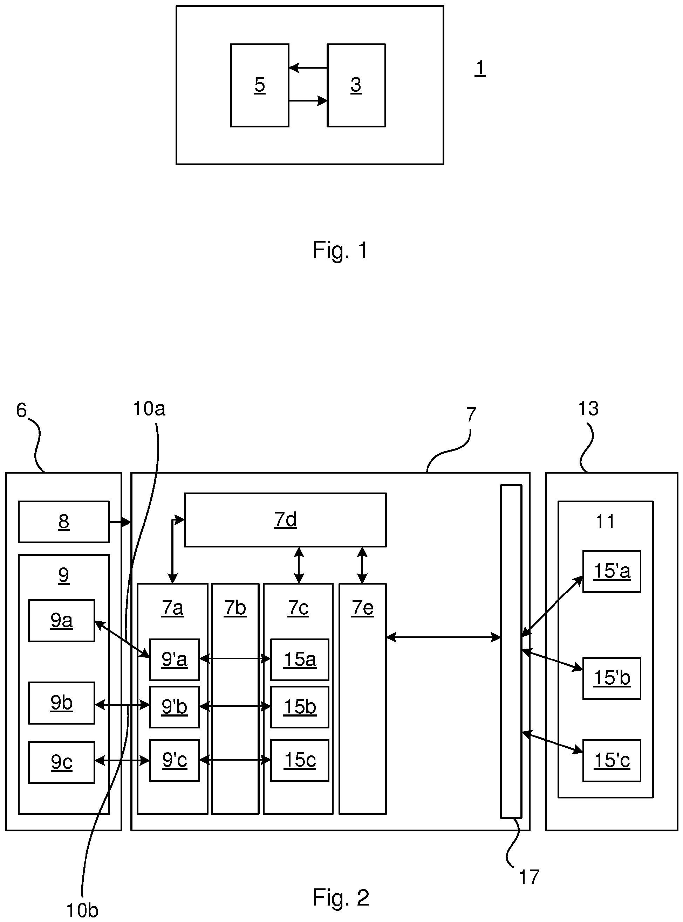

Fig. 1 shows an example of a test and simulation device 1. The test and simulation device 1 is configured to interface with a control system and comprises processing circuitry 3 and a storage medium 5.

The processing circuitry 3 may use any combination of one or more of a suitable central processing unit (CPU), multiprocessor, microcontroller, digital signal processor (DSP), application specific integrated circuit (ASIC), field programmable gate arrays (FPGA) etc., capable of executing any herein disclosed operations concerning testing and simulation.

The storage medium 5 may for example be embodied as a memory, such as a random access memory (RAM), a read-only memory (ROM), an erasable programmable read-only memory (EPROM), or an electrically erasable programmable read-only memory (EEPROM) and more particularly as a non-volatile storage medium of a device in an external memory such as a USB (Universal Serial Bus) memory or a Flash memory, such as a compact Flash memory.

The test and simulation device 1, and in particular the storage medium 5, may comprise computer code defining a test and simulation tool, configured to perform the methods disclosed herein when executed by the processing circuitry 3. The test and simulation tool may for example interface with the control system software by means of a plug-in or an application. The test and simulation tool does not form part of the control system software used for controlling control module types, such as valves and pumps. The test and simulation tool is hence external to the control system software in this sense.

Fig. 2 schematically shows a block diagram of a test and simulation tool 7 interfacing with a control system 6 using a plug-in 8. The test and simulation tool 7 is software, which is configured to interface with the control system software 9. The test and simulation tool 7 is furthermore configured to interface with external dynamic process models 11 of external dynamic process model software 13.

The control system includes control system software 9 which comprises controllers configured to control various entities or control module aspect types in the form of control module types 9a and 9b. The control module types may for example be different type of valves, pumps/motors, etc. In the example, control module type 9a is a "valve type A" and control module type 9b is a "valve type B".

The controllers are configured to communicate with field devices, such as sensors, by means of I/O. The control system software 9 thus comprises control module aspect types in the form of field device signal types, for example field device signal type 9c. The field device signal types are related to the I/O of the controllers. The controllers may for example be configured to control the control module types 9a and 9b based on field device signal type data of the corresponding field device signal type, such as field device signal type 9c. As an example, valve type A may be associated with a pressure sensor, and both of these entities may be associated with a specific controller of the control system 6. The field devices may have different signal types as defined by the field device signal types. The field device signal types may for example be different type of analog signal types or digital Boolean signal types.

The test and simulation tool 7 comprises a control interface 7a, a converter 7b, and a simulation interface 7c. The control interface 7a is populated with the control module aspect types of the control system 6 with the number of instances of each control module aspect type corresponding to that of the control system 6.

The control module types 9a and 9b are generally referred to as interfacing control module types 9'a and 9'b when they have been populated in the control interface 7a. The field device signal aspect type(s) 9c are generally referred to as interfacing field device signal aspect type 9'c when they have been populated in the control interface 7a.

This population or configuration may be obtained when the test and simulation tool 1 is initially set up, and may be automatically or manually generated for example by obtaining the current control module aspect type configuration and instances thereof from the control system software 9 via for example the plug-in 8.

There is a respective I/O port 10a and 10b between the control module types 9a and 9b in the control system software 9 and the interfacing control module types 9'a and 9'b in the control interface 7a of the test and simulation tool 7. There is a respective I/O port 10c between the field device signal types 9c of the control system 6 and the interfacing field device signal types 9'c in the control interface 7a.

The simulation interface 7c is populated with simplified general control module aspect types in the form of simplified general control module types 15a and 15b and in the form of simplified general field device signal types 15c. The simplified general control module types 15a and 15b are mappings of the interfacing control module types 9'a and 9'b, respectively. The simplified general field device signal types 15c are mappings of the interfacing field device signal types 9'c.

The simplified general control module types are simplified representations of the corresponding control module type 9a and 9b. The simplified general control module types 15a and 15b may communicate with simpler protocols, and may comprise fewer parameters than the interfacing control object types 9'a and 9'b. The simplified general field device signal types are simplified representations of the corresponding field device signal types 9c.

The above-described mapping may initially be made manually by a user. When a data set or library of mappings between interfacing control module types 9'a, 9'b and simplified general control module types 15a, 15b has been created and mappings between interfacing field device signal types 9'c and interfacing simplified general field device signal types 15c has been created, the mappings may be performed automatically when populating a future configuration.

The converter 7b is configured to provide a conversion between the interfacing control module types 9'a and 9'b of the control interface 7a and the simplified general control module types 15a and 15b of the simulation interface 7d. The converter 7b is configured to provide conversion between the interfacing field device signal types 9'c and the interfacing simplified general field device signal types 15c. This conversion may include both signal conversion, i.e. protocol conversion, and in the former case object type conversion.

The test and simulation tool 7 may further comprise a test interface 7d. The test interface 7d may include a user interface which allows a user to set the operation of the test and simulation tool 7. In particular, the test interface 7d enables a user to interact with the control interface 7a and with the simulation interface 7c.

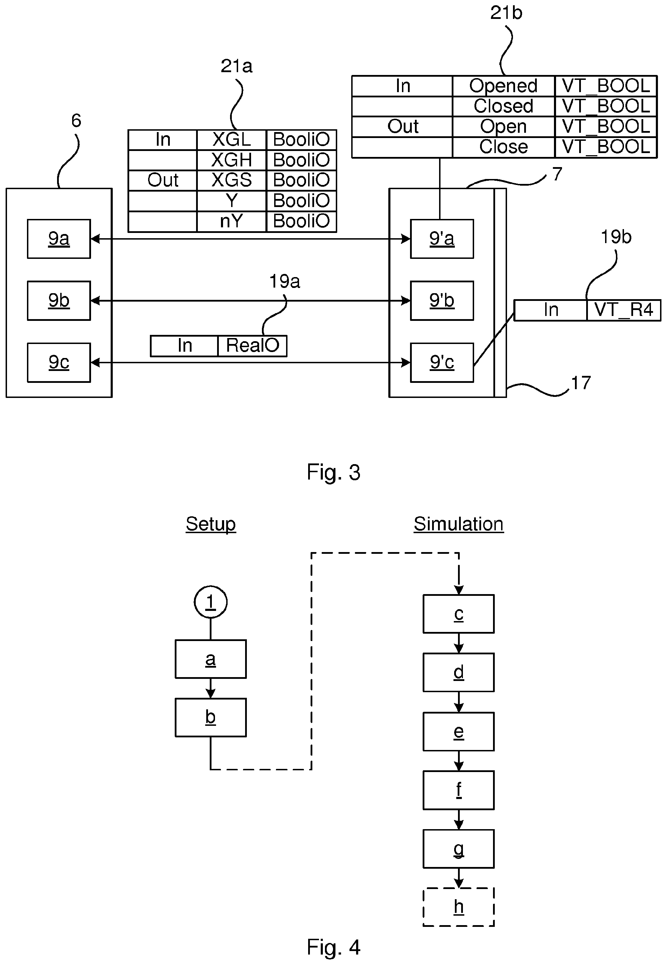

Additionally, the test and simulation tool 7 may include a simulation source block 7e, allowing a user to select a simulation source via the test interface 7d. The simulation source block 7e may be connected to a server such as an OPC server 17 via a simplified protocol. The simulation source block 7e communicates via simplified protocols, of a type available on the simulator interface side of the converter 7b. The server or OPC server 17 may in turn be connected to the external dynamic process modelling software 13, and in particular to an external dynamic process model 11 via the simpler protocol. The external dynamic process modelling software 13 comprises an external dynamic process model 11, including simplified general control module types 15'a and 15'b and simplified general field device signal type(s) 15'c interfacing with those of the simulation interface 7c, as shown in Fig. 3 which depicts a simplification of the test and simulation tool 7. In addition to being able to select simulation from the external dynamic process model 11, other simulation sources may also be selected by means of the simulation source block 7e via the test interface 7d. For example, in the case of communication with field device signal types, signal feedback simulation may be selected, and in the case of communication with control module types, device feedback simulation may be selected. A method for facilitating control system testing, and interfacing with an external dynamic process model by means of the test and simulation tool 7 will now be described with reference to Figs 3 and 4.

Steps a) and b) below concern the initial set-up, configuration, or population of the control module types and field device signal types in the test and simulation tool 7. Steps a) and b) may be carried out manually or automatically. These two steps are generally carried out once, to obtain the correct configuration or population concerning the interfacing control module types, and simplified general control module types and the interfacing field device signal types, and simplified general field device signal types.

In a step a) the control module types 9a and 9b and all of their instances are obtained for all controllers of the control system 6. The control module types 9a, 7b obtained by the test and simulation tool 7 are used to set up an interfacing control module type configuration corresponding to that of the control system 6 in the test and simulation tool 7. The interfacing control module type configuration includes the interfacing control module types 9'a and 9'b in the control interface 7a.

The field device signal types 9c are also obtained from the control system 6, in particular all instances of the field device signal types 9c are obtained by the test and simulation tool 7. The field device signal types 9c are used to set up interfacing field device signal types 9'c corresponding to those of the control system 6.

In a step b) each interfacing control module type is mapped to a respective simplified general control module type. In this manner, the simulation interface 7c is populated by the simplified general control module types 15a and 15b.

Additionally, each interfacing field device signal type is mapped to a respective simplified general field device signal type. In this manner, the simulation interface 7c is populated by the simplified general field device signal types.

The mapping in step b) involves finding a match between the interfacing control object types and the simplified general control module types in a data set or library comprising a plurality of simplified general control module types, each of which is associated with a particular control module type. In this manner the converter interface 7a and the simulator interface 7c are populated. The same applies also for the field device signal types and the simplified general field device signal types.

The above steps a) and b) may be carried out manually or automatically.

In a simulating operation, the method may involve the following steps.

The user may set up the particular simulation using the test interface 7d. When performing simulation involving field device signal types steps c)-g) may be carried out as described below. In this case, control module aspect type data is received in step c) by the test and simulation tool 7 in the form of field device signal type data. An example of field device signal type data is a pressure from a field device that is a sensor which measures pressure. An example of field device signal type data 19 is shown in Fig. 3. The field device signal type data 19a may then be converted in a step d) to simplified control module aspect type data in the form of simplified field device signal type data 19b. The simplified field device signal type data is provided to the corresponding simplified general field device signal type 15c in a step e). An operator may by using the test interface 7d select a particular simulation in a step f) to perform signal feedback simulation, whereby the simplified field device signal type data 19b is sent back to the control system 6 and the corresponding field device signal type 9c by converting it to feedback simulation data, or g) to send the simplified field device type data 19b to the external dynamic process model 11. This allows for testing of the controller in question.

In the control module aspect type data is control module type data 21, in step c) the control module type data 21a is received from a controller of the control system 6 via an I/O port of the test and simulation tool 7. For example, a controller associated with valve type A, or control module type 9a, may send control module type data, e.g. including a control signal, via the I/O port 10a to the control interface 7a, and in particular to the interfacing control module type 9a'.

In step d) the control module type data 21a is converted to simplified control module type data 21b based on the control module type or on the receiving interfacing control module type 9'b. The conversion is thus performed by the converter 7b.

In step e) the simplified control module type data 21b is provided to the simplified general control module type 15a, 15b.

In step f) a feedback simulation is performed using, or based on, the simplified general control module type and the simplified control module type data. This simulation is performed by the test and simulation tool 7, i.e. without utilising an external dynamic process model. The internal simulation type may be selected via the test interface 7d and the simulation source block 7e. For example, the simulation may concern device feedback simulation when performing steps c)-e) for control module type data.

Step f) may involve performing a feedback simulation using the simplified control module type data 21b to obtain feedback simulation data. The feedback simulation data is then fed back to the controller which sent the control module type data, in the control system 6 in a step h). Step h) involves converting the feedback simulation data to obtain converted feedback simulation data adapted to a protocol used by the controller, and sending the converted simulation data to the controller via the I/O port, in this example I/O port 10a. The converter 7b thus converts the feedback simulation data to obtain the converted feedback simulation data.

Alternatively, or additionally, in a step g) the simplified control module type data 21b may be sent from the test and simulation tool 7 to the external dynamic process model 11. Step g) may also involve sending feedback simulation data in the same manner as described in step h) back to the controller.

The above steps describe different simulation scenarios. The test and simulation tool 7 may however also be configured to enable testing of the control system 6. This testing may for example involve I/O testing, in which control module type data or field device signal type data is received by the test and simulation tool 7 and sent back to the control system 6 without performing any conversion or simulation as described above. Electronic test documentation and test scope may be provided by the test and simulation tool 7 to facilitate the test procedure.

The inventive concept has mainly been described above with reference to a few examples. However, as is readily appreciated by a person skilled in the art, other embodiments than the ones disclosed above are equally possible within the scope of the inventive concept, as defined by the appended claims.

## Claims

1. A computer-implemented method for facilitating testing of a control system (6), and interfacing of the control system with an external dynamic process model (11), by means of a test and simulation tool (7), the control system (6) comprising a plurality of control module aspect types (9a, 9b, 9c), each control module aspect type (9a, 9b, 9c) being one of a control module type (9a, 9b) and a field device signal type (9c), wherein the method comprises:
c) receiving, via an I/O port (10a, 10b) of the test and simulation tool (7), control module aspect type data (19a, 21a) from a control module aspect type (9a, 9b, 9c) of the control system (6),
d) converting the control module aspect type data (19a, 21a) to simplified control module aspect type data (19b, 21b) based on the control module aspect type (9a, 9b, 9c),
e) providing the simplified control module aspect type data (19b, 21b) to a simplified general control module aspect type (15a, 15b, 15c), the simplified general control module aspect type (15a, 15b, 15c) being a simplified representation of the control module aspect type (9a, 9b, 9c), and
f) performing a feedback simulation using the simplified general control module aspect type (15a, 15b, 15c) and the simplified control module aspect type data (19b, 21b), or
g) sending the simplified control module aspect type data (19b, 21b) from the test and simulation tool (7) to the external dynamic process model (11).

2. The method as claimed in claim 1, comprising, prior to step c), a) obtaining all control module aspect types (9a, 9b, 9c) of the control system (6) and all of their instances to set up interfacing control module aspect types (9'a, 9'b, 9'c) corresponding to that of the control system (6).

3. The method as claimed in claim 2, comprising b) mapping each interfacing control module aspect type (9'a, 9'b, 9'c) to a respective simplified general control module aspect type (15a, 15b, 15c).

4. The method as claimed in claim 3, wherein the mapping involves finding a match between the interfacing control module aspect types (9'a, 9'b, 9'c) and the simplified general control module aspect types (15a, 15b, 15c) of a data set comprising a plurality of simplified general control module aspect types (15a, 15b, 15c).

5. The method as claimed in any of claims 2-4, wherein step c) involves receiving the control module aspect type data (19a, 21a) by a corresponding interfacing control module aspect type (9'a, 9'b, 9'c).

6. The method as claimed in any of the preceding claims, wherein step f) involves performing a feedback simulation using the simplified control module type data (19b, 21b) to obtain feedback simulation data.

7. The method as claimed in claim 6, wherein in case the control module aspect type data (19a, 21a) is control module aspect type data (21a) the feedback simulation is a device feedback simulation and in case the control module aspect type data (19a, 21a) is field device signal type data (19a) the feedback simulation is a signal feedback simulation.

8. The method as claimed in claim 6 or 7, comprising h) sending feedback simulation data to the control module aspect type (9a, 9b, 9c).

9. The method as claimed in claim 8, wherein step h) involves converting the feedback simulation data to obtain converted feedback simulation data adapted to a protocol used by the I/O port (10a, 10b), and sending the converted simulation data to the control module aspect type (9a, 9b, 9c) via the I/O port (10a, 10b).

10. The method as claimed in any of the preceding claims, wherein the simplified general control module aspect type (9'a, 9'b, 9'c) has fewer state parameters than the control module aspect type (9a, 9b, 9c).

11. The method as claimed in any of the preceding claims, wherein step h) comprises sending the simplified control module aspect type data (19b, 21b) to the external dynamic process model (11) via an Object linking and embedding for Process Control, OPC, server (17).

12. A computer program comprising computer code which when executed by processing circuitry (3) of a test and simulation device (1) causes the test and simulation device (1) to perform the method as claimed in any of claims 1-11.

13. A computer program product comprising a storage medium provided with a computer program as claimed in claim 12.
